# EUROPEAN PATENT SPECIFICATION

(11) **EP 0 390 507 B1**
(45) Date of publication and mention of the grant of the patent: **10.01.1996**
(21) Application number: 90303266.2
(22) Date of filing: 27.03.1990
(51) Int. Cl.: G11C 7/00, G11C 11/416

(54) **Bit line discharge and sense circuit**
Bitleitungs-Entladung- und Abfühlschaltung
Circuit de décharge et de détection de ligne de bit

(30) Priority: 30.03.1989 US 331684
(43) Date of publication of application: 03.10.1990
(73) Proprietor: SYNERGY SEMICONDUCTOR CORPORATION, Santa Clara California 95051 (US)
(72) Inventor: Wong, Thomas Sing Wai, San Jose, California 95127 (US)
(74) Representative: Cross, Rupert Edward Blount

(56) References cited:
- EP-A- 0 216 264
- US-A- 4 322 820

## Description

### FIELD OF THE INVENTION

This invention relates generally to a high-speed static memory array, and more particularly to a discharge and sensing circuit for a static memory array.

### BACKGROUND OF THE INVENTION

The classic problem with sensing a bipolar random access memory is the high capacitance present along the bit lines. The total capacitance presented to the bit line is a function of the number of cells along the column to be read. Every cell along the column has at least one emitter tied to the bit line. So if 64 cells are tied to the column line, 64 emitters are tied to that column line. In most static memory cells, the emitter is heavily doped and the base is heavily doped, so that the emitter base capacitance is high. Assuming 64 cells on a column, 63 have reversed biased base-emitter junctions, resulting in very high bit line capacitance. All of this capacitance has to be charged and discharged to sense what is stored in a selected cell.

As shown by prior art Figure 1A and as typified by EP-A-0216264, a static memory cell includes two transistors which have opposite states. Reading the state of a given cell is a function of the sense circuit's ability to sense the voltage difference between bit lines tied to the emitters of the separate transistors which form a single cell. The only way to rapidly charge and discharge the capacitance of the transistors tied to the bit line to sense the cell state is with current; the higher the current the faster rate of charge and discharge.

However, cells classically cannot handle a high level of current. Too much current overloads the cell, so that the cell cannot be sensed or it is extremely difficult to sense. Due to the limitations imposed on the sensing current, one of the greatest sources of delay in bipolar memory arrays such as that described in EP-A-0216264, is the time required to discharge the bit lines, which is necessary before the contents of the specified cell may be accurately known. This may amount to as much as 50% of the total delay in reading a bipolar memory cell.

Therefore, the primary problem addressed by this invention is to provide a circuit arrangement and method for charging and discharging the capacitance tied to the bit lines very fast in order to maximize the speed with which a bipolar memory array can be read.

According to the present invention there is provided an arrangement for sensing the state of a cell of an array of static memory cells arranged in rows and columns, each cell comprising a pair of transistors whose different states define the value stored in said cell, the arrangement comprising, a single row select line connected to every cell in a row of said array, a pair of column select lines connected to every cell in a column of said array, means for selecting a cell in said array by selective activation of said row and column select lines, a first current source connected by a respective column select line to the respective emitter of a respective transistor of each cell in a selected column for discharging the capacitance effectively connected to the column select line during switching of the column, sensing means coupled to said transistors for sensing the value stored in said selected cell, characterised by a second current source providing a current of magnitude less than that provided by said first current source and coupled to the emitters of each selected cell, so that only a difference in the currents provided by said first and second current sources flows through said cell transistors.

In a preferred embodiment, the two current sources have a relatively small difference. The larger current source is used to discharge the capacitance on the bit line. However, only the difference between the two currents flows through the cell transistor being read. Thus, a high current flows in the bit line, but a much lower current in the cell.

Using this arrangement, the voltages on the bases of the two transistors of the cell can be sensed directly, by diode followers connected to the emitters of the two transistors of the cell. As the base of one transistor will be at a voltage level significantly higher than the sense level, and the base of the other transistor at a voltage level significantly lower, a simply constructed differential sense amplifier connected between the two diode followers which are connected to the emitters of the transistors of the cell will immediately indicate the state of the selected cell.

By adopting this configuration, the classic problem with the fact that the current which is used to charge the bit line capacitance also flows into the memory cell is overcome.

A further problem with the prior art is the delay which results from the inability to sense the bit line directly; that is, in the prior art either a sense transistor or a differential amplifier is used on every column, and the system essentially senses the collector of the sense transistor or the differential amplifier and develops the differential signal at that point. A preferred embodiment of this invention senses the nodes directly to get a direct reading of the voltage at the bit lines without the extra sense transistor or differential amplifier delay.

Examples of embodiments of the present invention will now be described with reference to the drawings, in which:-
FIG 1A, 1B and 1C illustrate the known and presently applied techniques for reading a cell of a bipolar memory array;
FIG 2 schematically illustrates the improved cell sensing arrangement of an embodiment of this invention;
FIG 3 illustrates the bit line switching characteristics of the array according to an embodiment of this invention; and
FIG 4 schematically illustrates a multicell memory array incorporating the improved feature of an embodiment of this invention.

### DETAILED DESCRIPTION OF A PREFERRED EMBODIMENT

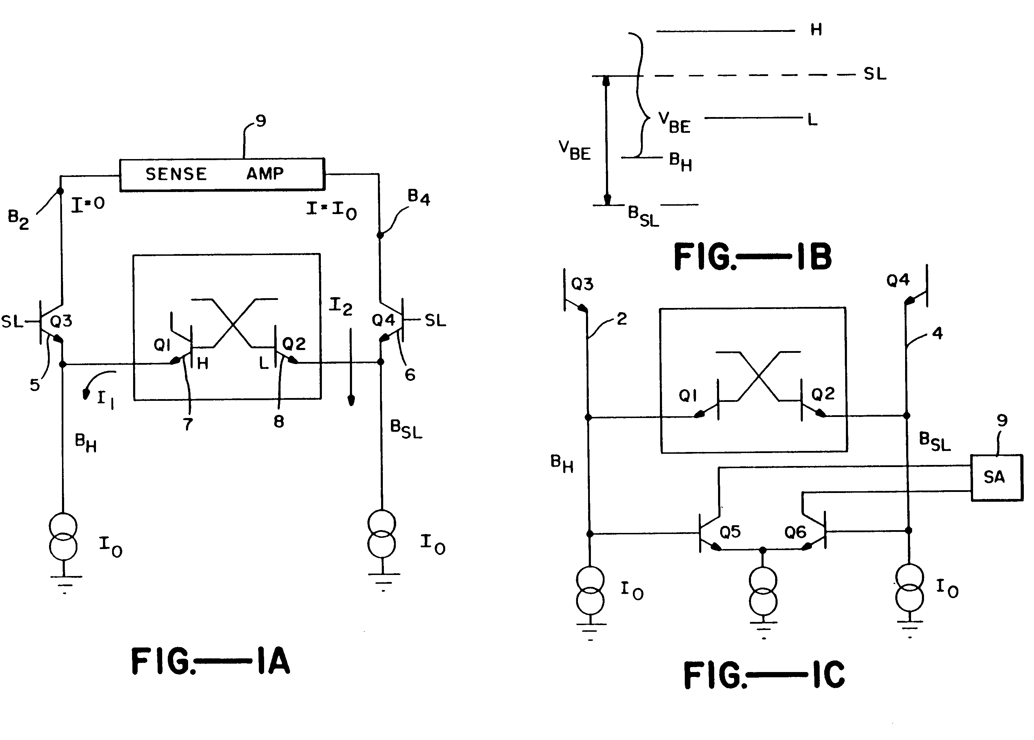

FIGs 1A and 1B illustrate a typical bipolar static random access memory cell including a pair of cross coupled transistors Q1 and Q2. A pair of sense transistors Q3, Q4 are provided with their emitters 5, 6 connected to the emitters 7, 8 of the cross-coupled transistors Q1, Q2 in the cell.

It is known that at any given time, the voltage level of the base of one of the transistors is High (H) and the voltage level of the base of the other transistor is Low(L); the respective voltage levels are shown in FIG 1B having higher and lower values respectively than the sense level voltage (SL). Thus, the pair of transistors Q1 and Q3 form a differential amplifier, as do the pair of transistors Q2 and Q4. In accordance with the standard operation of differential amplifiers, the transistor with the higher base voltage level takes all the current, whereas the transistor with the lower base voltage level takes no current. The current flow in this cell construction and with these relative voltage levels, is represented by the arrows I₁ and I₂.

On the left-hand side of the cell, I₁ is equal to I₀; on the right-hand side of the cell, I₂ is equal to I₀. By coupling a sense amplifier 9 between the sense nodes B2 and B4, this sense amplifier 9 can read the difference in the currents and determine the state of the cell.

Alternatively, as in FIG 1C, the voltage difference in such an arrangement can be sensed, since the voltage on the left-hand bit line 2 would be equal to B_{H}, (i.e., the voltage level H) minus V_{BE}; the voltage level on the right-hand bit line 4 would be equal to B_{SL}, i.e., voltage level SL minus V_{BE}. A differential amplifier, constructed of transistors Q5, Q6, and connected between the two bit lines would read these two voltages, and the output of the differential amplifier is the input to sense amplifier 9. However, as noted above with these structures, I₀ is strictly limited because this is the current that flows into the cell transistor which can easily be swamped by excessive current flow. In addition, the electrical signal has to pass through either sense transistors Q3, Q4 or the differential amplifier formed by Q5, Q6 which resulted in additional delay.

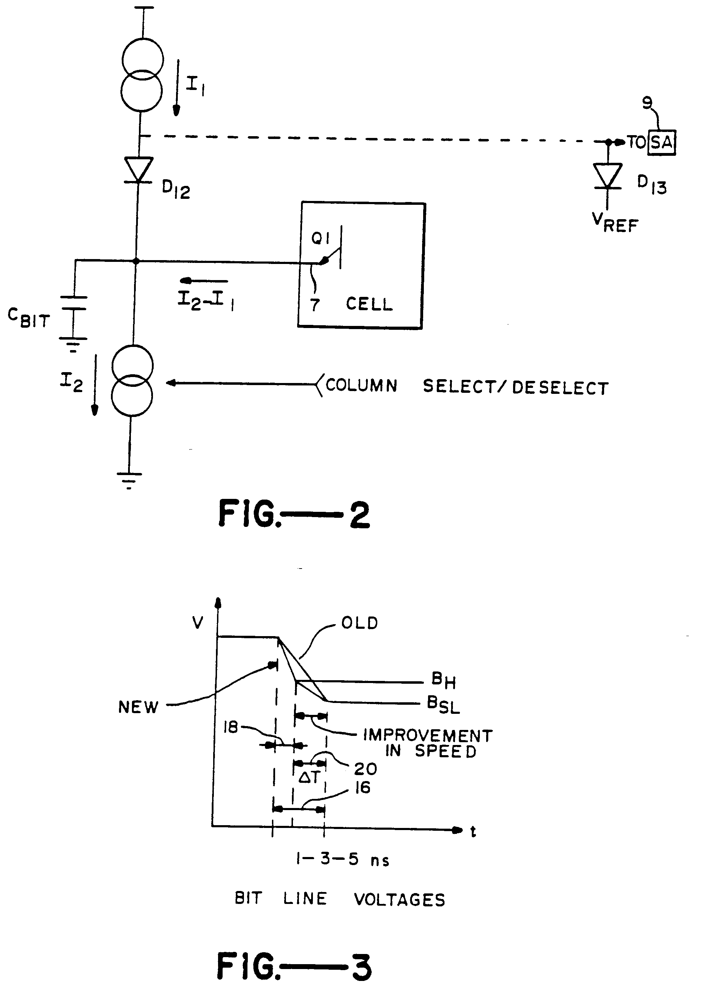

As explained in summary above, the objective herein is to maximize I₀ in order to rapidly charge and discharge the capacitance tied to the bit lines, and to eliminate extra delay through the critical delay path. In this invention this is achieved by the array shown schematically in FIG 2 which uses a pair of current sources I₂, I₁, connected to the sense amplifier with I₂ being greater than I₁. The difference between the two currents I₂, I₁, is the net current flow into the transistor Q1 of any selected cell. However, the full current I₂ which can be significantly larger than the current I₀ used in prior art bipolar memory arrays is available to discharge the bit line capacitance C_{BIT} during bit line switching.

In a further distinction from prior art arrangements, a diode D12 is added in series with the smaller current source I₁ between that current source and the node connected to the emitter 7 of the cell transistor. The diode D12 is necessary because current flow from current source I₁ is desirable only on the column that is active. The diode D12 can be reverse biased by a COLUMN SELECT signal which reverse biases the diode of every column which is not selected during a given read operation. In addition, in the preferred embodiment of this invention, a diode D13 is added to limit the voltage swing of the sense nodes.

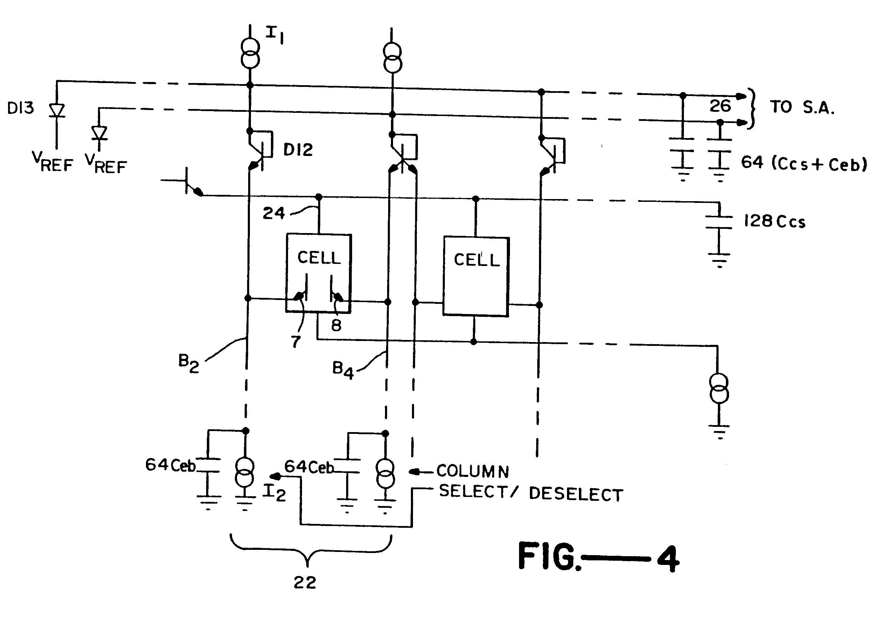

The improvement achieved by this modified design is dramatically illustrated by the timing chart of FIG 3. In typical bit line switching, an accurate read can be achieved only when the lines B2, B4 (FIG 1A) stabilize at the voltages represented by B_{H} and B_{SL}. In the graph of FIG 3, the time required for the voltages on the lines to stabilize sufficiently for the voltage differential to be accurately read by the differential amplifier 9 is represented by the arrow 16; this time lag be on the order of about 5 nanoseconds, as the rate of change of the voltage is linear. To read the voltage difference between the two transistors of a cell, the high voltage level V is removed, allowing the current I₀ flow to discharge the capacitance C_{BIT} tied to the bit line and the capacitances on the two sense nodes to stabilize at the indicated values.

The use of the higher level current flow I₂ to discharge the capacitors significantly reduces the time delay until the voltage differential can be read. As indicated in FIG 3, the delay until read can occur is now represented by the arrow 18; the improvement ΔT is represented by arrow 20. The improvement achieved by this invention can be from 1 to 3 nanoseconds' reduction in switching time.

The complete memory array of an embodiment of this invention is shown in FIG 4 and includes the bit lines B2, B4, a pair of which are connected to every cell in a column 22, and particularly the emitters 7, 8 of transistors Q1, Q2 of each column cell and the row select lines 24 one of which is connected to every cell in a row. One each of these row and bit lines are selectively activated to select a particular cell for reading at any given time. The capacitances C_{eb} (the emitter base capacitance of the transistors) and C_{cs} (the collector-substrate capacitance of the transistors) are also represented in this figure. The ability to use the large current I₂ to charge and discharge these capacitances significantly speeds up the cell read times herein.

The sense amplifier inputs 26 in this embodiment of the invention as can be clearly seen in FIG 4 are basically directly following the bit lines. The present system functions as a voltage follower to give an extremely rapid readout of the relative voltages on the two transistors in the cell. This provides extremely high speeds for reading the cells in the array. Other modifications of this invention may become apparent to a person of skill in the art who studies this invention disclosure. Therefore, the scope of this invention is to be limited only by the following claims.

## Claims

1. An arrangement for sensing the state of a cell of an array of static memory cells arranged in rows and columns, each cell comprising a pair of transistors (Q1,Q2) whose different states define the value stored in said cell, the arrangement comprising:
a single row select line (24) connected to every cell in a row of said array,
a pair of column select lines (B2,B4) connected to every cell in a column of said array,
means for selecting a cell in said array by selective activation of said row (24) and column select lines (B2,B4),
a first current source (I₂) connected by a respective column select line (B2,B4) to the respective emitter (7,8) of a respective transistor (Q1,Q2) of each cell in a selected column for discharging the capacitance effectively connected to the column select line during switching of the column, sensing means (9) coupled to said transistors (Q1,Q2) for sensing the value stored in said selected cell, characterised by a second current source (I₁) providing a current of magnitude less than that provided by said first current source (I₂) and coupled to the emitters (7,8) of the selected cell, so that only a difference in the currents provided by said first and second current sources (I₂, I₁) flows through said cell transistors (Q1,Q2) .

2. An arrangement as claimed in Claim 1, including diode means (D12) coupled in each said column select line (B2,B4) between said second current source (I₁) and said respective emitter (7,8) and means coupled to said column select lines (B2,B4) to provide selective switching off of said diode means (D12) on column select lines not selected for reading to isolate said cell from said second current source (I₁).

3. An arrangement as claimed in Claim 1 or 2, including a pair of select lines (SL) coupled to the cell transistors (Q1,Q2) and wherein said means for sensing (9) is a sense amplifier (9) comprising a voltage follower connected across said pair of select lines (SL) for rapidly reading the voltage differential between said two cell transistors (Q1,Q2).

4. An arrangement as claimed in any preceding claim, further including a diode (D13) coupled to each said second current source (I₁), and a reference voltage (V_{ref}) for limiting voltage swing of said second current source.

5. An arrangment as claimed in Claim 1, wherein said sense means (9) includes diode followers (D12) connected between the emitters of the two cell transistors (Q1,Q2) and said second current source (I₁) for directly sensing the voltages on the bases of said two cell transistors (Q1,Q2).

6. An arrangement as claimed in Claim 5, wherein said sense means (9) further comprises a differential amplifier (9) connected between said diode followers (D12) to immediately indicate the state of the selected cell.

## Patentansprüche

1. Anordnung zum Erfassen des Zustands einer Zelle eines Felds in Zeilen und Spalten angeordneter statischer Speicherzellen, wobei jede Zelle ein Paar Transistoren (Q1, Q2) aufweist, deren verschiedene Zustände den in der Zelle gespeicherten Wert bestimmen, wobei die Anordnung folgende Elemente enthält:
eine einzelne Zeilen-Auswahlleitung (24), die mit jeder Zelle in einer Zeile des Felds verbunden ist,
zwei Spalten-Auswahlleitungen (B2, B4), die mit jeder Zelle in einer Spalte des Felds verbunden sind,
eine Einrichtung zum Auswählen einer Zelle im Feld durch wahlweises Aktivieren der Zeilen- (24) und Spalten-Auswahlleitungen (B2, B4),
eine erste Stromquelle (I₂), die über eine entsprechende Spalten-Auswahlleitung (B2, B4) mit dem entsprechenden Emitter (7, 8) eines entsprechenden Transistors (Q1, Q2) der jeweiligen Zelle in einer ausgewählten Spalte verbunden ist, so daß die während des Schaltens der Spalte wirksam mit der Spalten-Auswahleinrichtung verbundene Kapazität entladen wird, eine Erfassungseinrichtung (9), die zum Erfassen des in der ausgewählten Zelle gespeicherten Werts mit den Transistoren (Q1, Q2) verbunden ist, gekennzeichnet durch eine zweite Stromquelle (I₁), die einen Strom liefert, der geringer ist als der von der ersten Stromquelle (I₂) gelieferte Strom, und die an die Emitter (7, 8) der ausgewählten Zelle angeschlossen ist, so daß nur eine Differenz der von der ersten und der zweiten Stromquelle (I₂, I₁) gelieferten Ströme durch die Zellentransistoren (Q1, Q2) fließt.

2. Anordnung nach Anspruch 1, mit Diodeneinrichtungen (D12), die in der jeweiligen Spalten-Auswahlleitung (B2, B4) zwischen die zweite Stromquelle (I₁) und den entsprechenden Emitter (7, 8) geschaltet sind und einer Einrichtung, die an die Spalten-Auswahlleitungen (B2, B4) angeschlossen ist, wodurch diejenigen Diodeneinrichtungen (D12) auf Spalten-Auswahlleitungen selektiv ausgeschaltet werden, die nicht zum Lesen ausgewählt sind, um die Zelle von der zweiten Stromquelle (I₁) zu isolieren.

3. Anordnung nach Anspruch 1 oder 2, mit einem Paar an die Zellentransistoren (Q1, Q2) angeschlossener Auswahlleitungen (SL), bei der die Einrichtung zum Erfassen (9) ein Erfassungsverstärker (9) ist mit einem zwischen das Paar Auswahlleitungen (SL) geschalteten Spannungsfolger, wodurch die Spannungsdifferenz zwischen den beiden Zellentransistoren (Q1, Q2) schnell abgelesen werden kann.

4. Anordnung nach einem der vorangehenden Ansprüche, weiter mit einer an die jeweilige zweite Stromquelle (I₁) angeschlossenen Diode (D13) und einer Referenzspannung (V_{ref}) zum Begrenzen des Spannungshubs der zweiten Stromquelle.

5. Anordnung nach Anspruch 1, bei der die Erfassungseinrichtung (9) zwischen die Emitter der beiden Zellentransistoren (Q1, Q2) und die zweite Stromquelle (I₁) geschaltete Diodenfolger (D12) zum direkten Erfassen der Spannungen an den Basen der beiden Zellentransistoren (Q1, Q2) aufweist.

6. Anordnung nach Anspruch 5, bei der die Erfassungseinrichtung (9) weiter einen Differenzverstärker (9) aufweist, der zum sofortigen Anzeigen des Zustands der ausgewählten Zelle zwischen die Diodenfolger (D12) geschaltet ist.

## Revendications

1. Disposition pour détecter l'état d'une cellule d'une rangée d'éléments de mémoire statique disposés en rangs et colonnes, chaque cellule comprenant une paire de transistors (Q1, Q2) dont les différents états définissent la valeur emmagasinée dans ladite cellule, la disposition comprenant :
une seule ligne (24) de sélection de rang connectée à chaque cellule dans un rang de ladite rangée,
une paire de lignes (B2, B4) de sélection de colonne connectée à chaque cellule dans une colonne de ladite rangée,
des moyens agencés pour sélectionner une cellule dans ladite rangée par activation sélective desdites lignes de sélection de rang (24) et de colonne (B2, B4),
une première source (I₂) de courant reliée par une ligne respective (B2, B4) de sélection de colonne à l'émetteur respectif (7, 8) d'un transistor (Q1, Q2) respectif de chaque cellule dans une colonne sélectionnée pour décharger la capacitance effectivement connectée à la ligne de sélection de colonne lors de la commutation de la colonne,
un détecteur (9) connecté auxdits transistors (Q1, Q2) pour détecter la valeur emmagasinée dans ladite cellule sélectionnée,
caractérisée par une deuxième source (I₁) de courant qui fournit un courant d'une intensité inférieure à celle fournie par ladite première source (I₂) de courant et connectée aux émetteurs (7, 8) de la cellule sélectionnée, de sorte que seulement une différence dans les courants fournis par lesdites première et deuxième sources (I₂, I₁) de courant passe à travers lesdits transistors (Q1, Q2) de cellule.

2. Disposition suivant la revendication 1, comprenant une diode (D12) connectée dans chacune des lignes (B2, B4) de sélection de colonne entre ladite deuxième source (I₁) de courant et ledit émetteur (7, 8) respectif et des moyens connectés auxdites lignes (B2, B4) de sélection de colonne pour fournir un débranchement sélectif de ladite diode (D12) sur des lignes de sélection de colonne non sélectionnées pour une lecture, pour isoler ladite cellule de la deuxième source (I₁) de courant.

3. Disposition suivant la revendication 1 ou 2, comprenant une paire de lignes de sélection (SL) connectée aux transistors (Q1, Q2) de cellule et dans laquelle ledit détecteur (9) est un amplificateur de détection (9) qui comprend un étage asservi connecté à travers ladite paire de lignes de sélection (SL) pour rapidement lire la différence de tension entre lesdits deux transistors (Q1, Q2) de cellule.

4. Disposition suivant l'une quelconque des revendications précédentes, comprenant en plus une diode (D13) connectée à ladite deuxième source (I₁) de courant, et une tension de référence (V_{ref}) pour limiter l'oscillation de tension de ladite deuxième source de courant.

5. Disposition suivant la revendication 1, dans laquelle ledit détecteur (9) comprend des suiveurs de diode (D12) connectés entre les émetteurs des deux transistors (Q1, Q2) de cellule et ladite deuxième source (I₁) de courant pour détecter directement les tensions aux bases desdits transistors (Q1, Q2) de cellule.

6. Disposition suivant la revendication 5, dans laquelle ledit détecteur (9) comprend en plus un amplificateur différentiel (9) connecté entre lesdits suiveurs de diode (D12) pour indiquer immédiatement l'état de la cellule sélectionnée.
